# EUROPEAN PATENT SPECIFICATION

(11) **EP 1 104 012 B1**
(45) Date of publication and mention of the grant of the patent: **31.12.2008**
(21) Application number: 00204178.8
(22) Date of filing: 23.11.2000
(51) Int. Cl.: H01L 21/316, H01L 21/00

(54) **Method for forming an oxide layer on semiconductor wafers**
Verfahren zur Herstellung einer Oxidschicht auf einem Halbleiterwafer
Procédé de formation d'une couche d'oxyde sur une plaquette semiconductrice

(30) Priority: 25.11.1999 NL 1013667
(43) Date of publication of application: 30.05.2001
(73) Proprietor: ASM INTERNATIONAL N.V., 3720 AC Bilthoven (NL)
(72) Inventor: Vermeulen, Willem Job Cornelis, 3708 GE Zeist (NL); Philippsen, Bengt, 3000 Leuven (BE); Wierts, Erik, 1097 PB Amsterdam (NL); Beulens, Jacobus Johannes, 3723 WN Bilthoven (NL); Oosterlaken, Theodorus Gerardus Maria, 3421 GT Oudewater (NL)
(74) Representative: Prins, Adrianus Willem

(56) References cited:
- EP-A- 0 274 779
- EP-A- 0 671 761
- WO-A-98/50606
- WO-A-99/03141
- US-A- 5 648 282
- US-A- 5 810 929

## Description

The invention relates to a method according to the preamble of claim 1.

Such a method is known from practice and are used, inter alia, with the wafer processing furnaces marketed by applicant. The known furnaces may be provided with one or a number of furnace chambers or process chambers. The process chambers of the furnaces marketed by applicant are so-called hot wall process chambers. Such hot wall process chambers have the advantage of possessing a highly uniform temperature distribution in the process chamber.

In order to achieve a great production capacity, a large number of wafers are processed simultaneously in a single process step in a single process chamber. As the wafers are arranged one above the other, usually in a so-called boat, the process chamber, in practice referred to as vertical process chamber, occupies small footprint, which is of particular advantage specifically in clean rooms. After all, a square meter of clean room is highly costly. Moreover, with a vertical process chamber, an excellent, uniform temperature distribution in the process chamber can be achieved, as a result of which the wafers at the bottom as well as at the top of the process chamber acquire substantially the same properties after a process step.

A process which wafers may undergo is the formation of an oxide layer on the wafers. Such oxide layer constitutes an insulating layer and the accuracy of the thickness of such oxide layer is crucial. In particular the uniformity of the thickness of the oxide layer over the entire wafer surface is of great importance. From practice, two methods are presently known for forming an oxide layer. In the first method, oxygen is introduced into the process chamber. This oxygen is obtained from a gas cylinder containing compressed oxygen. However, forming an oxide layer by means of pure oxygen is a relatively slow process. In the second known method, water vapor is introduced into the process chamber. Forming an oxide layer by means of water vapor proceeds more quickly than in the method in which oxidation is effected by means of oxygen. Moreover, the structure of the oxide layer that is obtained by water vapor differs from the structure of the oxide layer obtained by oxygen. In practice, the structure of the oxide layer obtained by water vapor is preferred.

From practice, a number of different manners of introducing water vapor into the process chamber are known.

Thus, for instance oxygen or an inert gas was passed through a vessel containing water. By varying the temperature of the water in the vessel, the vapor pressure of the water changed and the amount of water vapor entrained by the oxygen or the inert gas could be influenced. The water vapor-saturated gas was subsequently introduced into the process chamber. A drawback of this known method of forming water vapor is that the vessel containing the water should regularly be filled with water. Another drawback is that pure water is a fairly aggressive liquid in which all types of impurities, for instance from the wall of the vessel, readily dissolve. These impurities form defects in the oxide layer to be formed on the wafer.

Presently, for forming water vapor, a torch is used. Such torch comprises an oxygen supply and a hydrogen supply whose outlet openings are located in each other's proximity, so that the oxygen and the hydrogen mix together directly. When the supply of oxygen and hydrogen to the torch is started, a temperature should be created at the outlet openings such that the oxygen/hydrogen mixture ignites. Once the ignition has started, it will be maintained due to the continuous supply of oxygen and hydrogen, without requiring external heating of the torch. Originally, the torch was located in the process chamber; a so-called internal torch system (ITS). However, an ITS has the drawback that the flame formed by the hydrogen/oxygen reaction disturbs the temperature distribution in the furnace. For that reason, the torch is presently disposed outside the process chamber in a reaction chamber; a so-called outside torch system (OTS), such as, for instance, according to US Patent 5,810,929. However, an OTS still entails some drawbacks. If the hydrogen supply is too great, the flame of the OTS becomes so large that overheating of the reaction chamber occurs. Further, in the case of great gas streams, it is difficult, if not impossible, to realize the sufficiently high torch temperature required for a reliable ignition. In that case, the mixture, in itself explosive, does not ignite, but accumulates in the reaction chamber. It is observed that the danger of explosion is present in particular in wafer processing furnaces in which substantially atmospheric pressure prevails. In connection with this invention, "substantially atmospheric" should be understood to mean a pressure in the range of 0.3-1.5 bar, more in particular 0.8-1.1 bar. Accordingly, extensive safety measures are necessary to prevent the creation of accumulations of mixtures of hydrogen and oxygen which have not yet entered into a reaction and which are explosive. If the gas stream is too slight, the flame will be in such an intimate contact with the torch that overheating of the tip of the torch occurs, causing erosion of the torch. This causes contamination of the water vapor formed, which leads again to defects in the oxide layer to be formed.

In the prior art, it has been proposed to form the water vapor by causing hydrogen and water vapor to react at a relatively low temperature, under the influence of a catalyst, see, for instance, Ohmi, EP 0671761, and T. Nagahama et al., RTP'98, September 9-11, 1998, Kyoto, Japan, T. Hori, B. Lojek, Y. Tanabe and R.P.S. Thakur (Chairs/editors), pages 140-143. A drawback of this method is that the catalyst material contains a metal. This involves the risk of catalyst material being released with the water vapor to be formed thereon. It is highly undesirable that the silicon wafers to be oxidized are contaminated by the catalyst material. In addition, information about the degree of conversion to be reached is not unequivocal. In the above-cited patent EP 0671761, a degree of conversion of 100% is reported, while T. Nagahama et al. report a degree of conversion of 99.5%. For applications where an excess of hydrogen is used, i.e. more than twice as much hydrogen as oxygen, so that, after reacting of the hydrogen with the oxygen according to 2H₂+O₂→2H₂O, an amount of free hydrogen remains present in the gas mixture, a residual concentration of oxygen in the gas may be very disadvantageous.

The object of the invention is to provide a method for forming an oxide layer on a wafer manufactured from semiconducting material without the above-described drawbacks. To this end, the invention provides the method according to claim 1.

By means of such method, an oxide layer can nevertheless be formed without the use of a torch, by means of water vapor. As a result of the use of water vapor, the growth rate of the oxide layer is fairly great. In the proposal according to the invention, the danger of explosion that is normally involved in the mixing of oxygen with hydrogen is overcome by contacting the oxygen and the hydrogen with each other only after one of the two or both have first been substantially diluted with an inert gas, or by mixing only a slight amount of hydrogen with an excess of oxygen. As a result, there will occur no self-sustaining reaction between the oxygen and the hydrogen. The reaction between the oxygen and the hydrogen molecules only takes place under the influence of the heat supplied to the substantially diluted mixture. By controlling the amount of heat supplied, the reaction rate can be influenced. At very low concentrations of hydrogen and/or oxygen, as in the method according to the invention, the reaction between these substances only occurs at a temperature of at least about 700 °C.

An additional advantage of this method is that the reaction between the hydrogen and oxygen can take place without these gases, for that purpose, contacting a material which may contaminate the oxide layer to be formed, for instance catalyst material. Hence, the reaction can take place in an inert environment, for instance in a reaction space surrounded by a quartz wall or in the furnace space itself.

In accordance with a further elaboration of the invention, the heating of the third gas mixture can take place by introducing the third gas mixture into the process chamber.

In accordance with an alternative further elaboration, however, it is also possible that the heating of the third gas mixture takes place by introducing it into a reaction chamber in which an increased temperature prevails, whereupon the water vapor-containing third gas mixture formed therein is introduced into the process chamber.

To obtain a uniform distribution of the water vapor in the process chamber, in accordance with a further elaboration of the invention, it is preferred when the third gas mixture be introduced into the process chamber from the top side of this process chamber. Preferably, the third gas formed according to the invention contains a concentration of hydrogen of from about 0.01 vol.% to about 6 vol.%, more in particular from about 0.1 vol.% to about 4 vol.%. The concentration of oxygen in the third gas formed according to the invention is preferably of from about 0.01 vol.% to about 100 vol.%, more in particular from about 0.1 vol.% to about 100 vol.%. With such concentrations, the risk of explosions is nil. An additional advantage of the invention is that it allows working with more than twice as much hydrogen as oxygen without any risks, so that after the reaction of the hydrogen with the oxygen according to the reaction 2H₂+O₂→2H₂O, an amount of unbound hydrogen still remains present in the gas mixture, which may add to the properties of the oxide.

In a further elaboration of the invention, the method according to the invention wherein unbound hydrogen remains present in the third gas mixture is applied to silicon wafers containing electrodes of transition metals and more in particular electrodes of tungsten. It has been found, see for instance Nitin Shah and Rahul Sharangpani, "Selective Oxidation by hydrogen-rich steam", European Semiconductor, November 1999, pages 21-22, that in hydrogen-rich steam, silicon oxidizes whereas tungsten does not. This is advantageously used after the etching of a gate stack. The oxidation is needed for removing damage in the silicon, caused by etching, while the metal present in the gate stack must not be oxidized. This is realized by carrying out the oxidation in steam with an excess of hydrogen and the absence of oxygen. Under these conditions, the reduction of the metal by H₂ is thermodynamically favored relative to the oxidation thereof by H₂O, while oxidation of silicon does occur under these conditions. In the prior art, this selective oxidation takes place under atmospheric pressure. The problems involved therein are described on page 22 of said publication and are, inter alia: the safety when working with hydrogen-rich mixtures, the controlled generation of small amounts of steam, the problem of in-situ generation of steam in a cold-wall reactor in which H₂ and O₂ mixtures on the hot wafer surface react to form hydrogen-rich steam, while the uniformity of the gas composition is not properly guaranteed. All these drawbacks are removed by carrying out the selective oxidation according to the method of the present invention. Through experiments, it has been found that when a concentration of hydrogen and oxygen in nitrogen is used, such that a mixture containing 2 vol.% of H₂O and 2 vol.% of H₂ is formed therefrom, the oxidation of tungsten is effectively prevented, while silicon is oxidized. For that purpose, silicon wafers, with successively applied thereto 100 nm of SiO₂, 200 nm of TiN and 400 nm of W are exposed for 35 minutes to nitrogen containing 2 vol. % of H₂O in a furnace at a temperature of 900 °C. Three different gas compositions are used, resulting in three different resistances of the layer, measured after the furnace treatment:

| | Gas composition | Resistance |
|---|---|---|
| a | 2 vol.% H₂O + 2 vol.% H₂ in N₂ | 0.205 ohms/sq |
| b. | 2 vol.% H₂O in N₂ | 0.258 ohms/sq |
| c. | 2 vol.% H₂O + 2 vol.% O₂ in N₂ | 7.35 ohms/sq |

The furnace treatment with an of excess hydrogen, according to gas composition a., results in a low resistance of the layer, while the metallic appearance of the tungsten layer is maintained. With gas composition b., the tungsten layer is slightly oxidized, resulting in a slight increase of the resistance and the tarnishing of the tungsten surface. With an excess of oxygen according to gas composition c., the tungsten layer is strongly oxidized, which results in a dramatic increase of the resistance and the entire browning and partial release of the tungsten layer. In the furnace treatment, carried out as a so-called batch process, bare silicon wafers are subjected to the gas exposure simultaneously with the wafers with the tungsten layer thereon. The SiO₂ layer thickness formed on this bare silicon wafers due to the different gas atmospheres was about 5 nm for gas atmospheres a. and b. and 7.9 nm for gas atmosphere c. This demonstrates that the method according to the present invention is effective for this application. As indicated earlier, applying the method according to the invention involves no risks regarding danger of explosion and the method is pre-eminently suitable for the controlled formation of a small amount of steam.

In accordance with a further elaboration of the invention, the hydrogen contains the isotope deuterium.

The use of deuterium has proved to be advantageous for the properties of the oxide layer, see for instance US 5,972,765. Although the deuterium isotope is very costly, through the method of the present invention, such a low concentration of hydrogen gas can be used that the total costs remain economically sound.

In accordance with a further elaboration of the invention, the inert gas may, for instance, be nitrogen or a noble gas.

Further elaborations of the invention are described in the subclaims and will hereinafter be further explained on the basis of a number of exemplary embodiments, with reference to the accompanying drawings.

It should be noted that WO99/03141 describes a method and apparatus for in situ vapor generation. In this publication the following is stated:
"Present steam oxidation processes generally take place in multi-wafer resistively heated "hot wall" furnaces. Presently steam oxidation processes typically use a pryrogenic torch or bubbler located outside of the reaction chamber in which the steam oxidation process is to take place."
   and
"A problem associated with pyrogenic torch methods, is that for safety reasons only certain concentration ratios of hydrogen containing gas and oxygen containing gas can be utilized. Limiting the available gas ratio unduly restricts ones ability to generate ambients with desired concentrations of H2O/H2 or H2O/O2"
   and
"Bubbles are also undesirable for moisture generation in that they can be a significant source of contamination and because they cannot accurately and reliably control the amount of moisture generated."
   and
"Thus, what is desired is a method and apparatus for generating moisture in a rapid thermal heating apparatus which does not suffer from contamination and safety issues and which can use a full spectrum of gas mixtures as well as concentration ratios."

In other words, WO99/03141 finds its solution to the problems described therein, which are the same problems with which the present application deals, in another manner, namely by changing from a furnace with the "hot wall" type of process chamber to the "cold wall" rapid thermal heating apparatus which utilize light sources for rapid temperature ramps and reaction times measured in terms of seconds as opposed to minutes and hours. As stated in WO99/03141:
"Rapid thermal heaters are preferred over resistively heated furnaces because of their excellent temperature uniformity and control provides more for uniform processing and because their short reaction times reduce the thermal budget of fabricated devices."

The present invention provides another solution for the mentioned problems without departing from the "hot wall" furnace.
Fig. 1 shows a schematic flow diagram of a part of a first exemplary wafer processing furnace;
Fig. 2 shows a similar diagram as shown in Fig. 1 of a second exemplary furnace;
Fig. 3 shows a similar diagram as shown in Fig. 1 of a third exemplary furnace;
Fig. 4 shows a similar diagram as shown in Fig. 1 of a fourth exemplary furnace;
Fig. 5 shows a similar diagram as shown in Fig. 1 of a fifth exemplary furnace;
Fig. 6 shows a similar diagram as shown in Fig. 1 of a sixth exemplary furnace;
Fig. 7 shows a similar diagram as shown in Fig. 1 of a seventh exemplary furnace; and
Fig. 8 is a sectional view of a process chamber of a wafer processing furnace.

All schematically shown examples of a wafer processing furnace have at least one process chamber 1 provided with heating means 2 for heating the interior and the walls 3 of the process chamber 1. The process chamber 1 extends in vertical direction and has such dimensions that a number of wafers W, disposed one above the other in a boat 4, can be processed simultaneously. The process chamber 1 has a bottom end thereof provided with a closable loading and unloading opening 5, closable by a door 6. Further, the process chamber 1 is provided with at least one gas supply 7 and at least one gas discharge 8. During the application of an oxide layer on a number of wafers W located in the process chamber, substantially atmospheric pressure prevails in the process chamber 1. Further, the examples shown all comprise a gas source and pipe assembly 9 which is in fluid connection with said at least one gas supply 7. By means of the gas source and pipe assembly 9, a third gas mixture is created from a first gas containing hydrogen and a second gas containing oxygen, the concentration of hydrogen in the first gas and/or the concentration of oxygen in the second gas and/or the ratio of the flow rates of the first and the second gas being such that during mixing of the first and the second gas, explosion of the third gas mixture formed therefrom is impossible in that the reaction between the oxygen and the hydrogen does not propagate automatically, due to the slight concentration. Preferably, the third gas mixture is created in an inert environment and, if necessary, transported further, such that no material capable of contaminating the oxide to be formed can be incorporated into the gas mixture.

The exemplary furnaces differ from each other by the design of the gas source and pipe assembly 9.

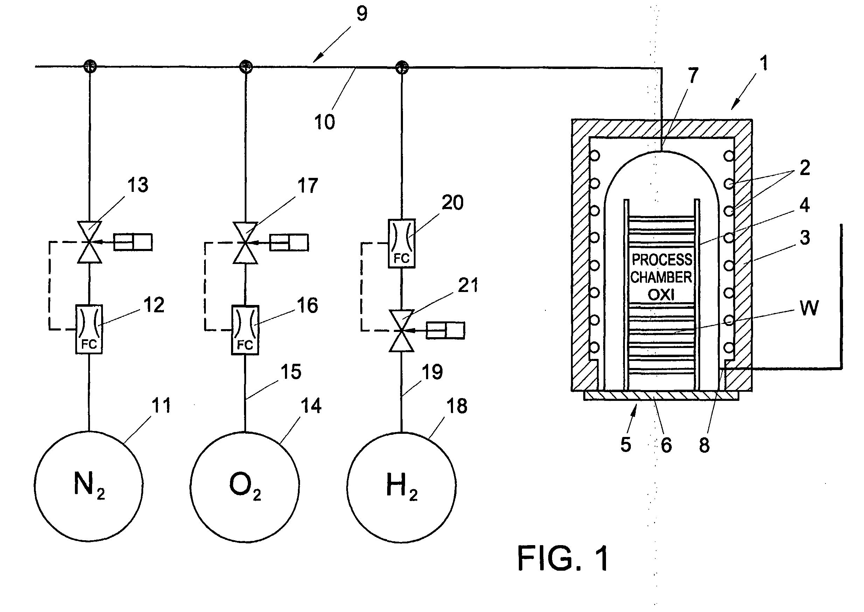

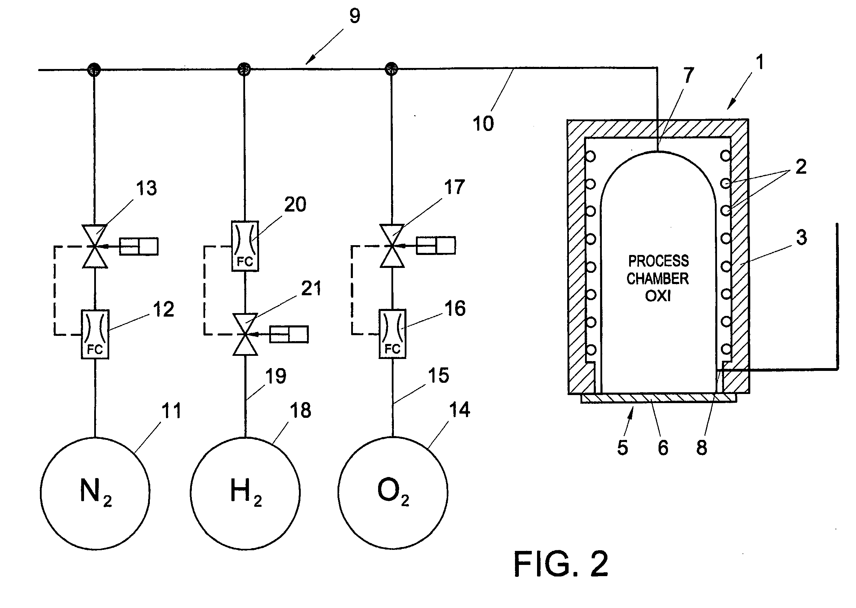

In Figs. 1 and 2, the gas source and pipe assembly 9 comprises a main supply pipe 10 having a downstream end thereof connected to the gas supply 7 of the process chamber 1. Via a flow control 12 and a stop valve 13, an inert gas source 11 is connected to an upstream end of the main pipe 10. Via an oxygen supply pipe 15 with flow control 16 and a stop valve 17, an oxygen source 14 is connected to the main pipe 10 between the upstream and the downstream end of the main pipe 10. Further, between the upstream and the downstream end of the main pipe 10, a hydrogen supply pipe 19 with a flow control 20 and stop valve 21 opens. Connected to the free end of the hydrogen supply pipe 19 is a hydrogen source 18. It is observed that the oxygen source 14 and/or the hydrogen source 18 can also contain a highly diluted amount of oxygen or hydrogen respectively. The oxygen and/or the hydrogen can be diluted therein with an inert gas, such as, for instance, nitrogen.

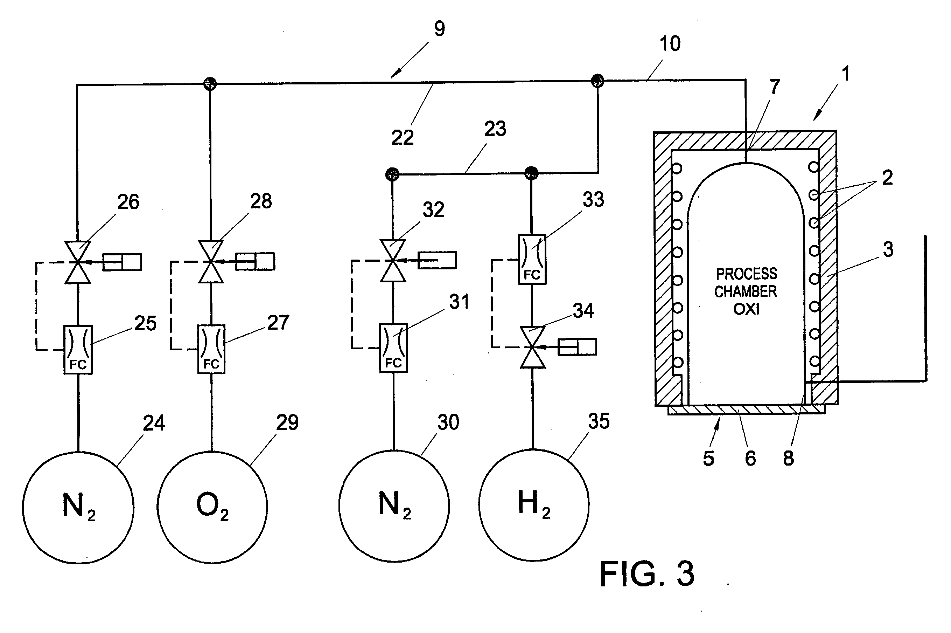

Fig. 3 shows an example in which the gas source and pipe assembly 9 comprises a main supply pipe 10 having a downstream end thereof connected to the gas supply 7 of the process chamber 1. Connected to an upstream end of the main pipe 10 are an oxygen mixture supply pipe 22 and a hydrogen mixture supply pipe 23. Via a flow control 25 and a stop valve 26, an inert gas source 24 is connected to an upstream end of the oxygen mixture supply pipe 22. Via a flow control 27 and a stop valve 28, an oxygen source 29 between the upstream end of the oxygen mixture supply pipe 22 and the upstream end of the main pipe 10 is connected to the oxygen mixture supply pipe 22. Via a flow control 31 and a stop valve 32, an inert gas source 30 is connected to an upstream end of the hydrogen mixture supply pipe 23. Via a flow control 33 and a stop valve 34, a hydrogen source 35 between the upstream end of the hydrogen mixture supply pipe 23 and the upstream end of the main pipe 10 is connected to the hydrogen mixture supply pipe 23.

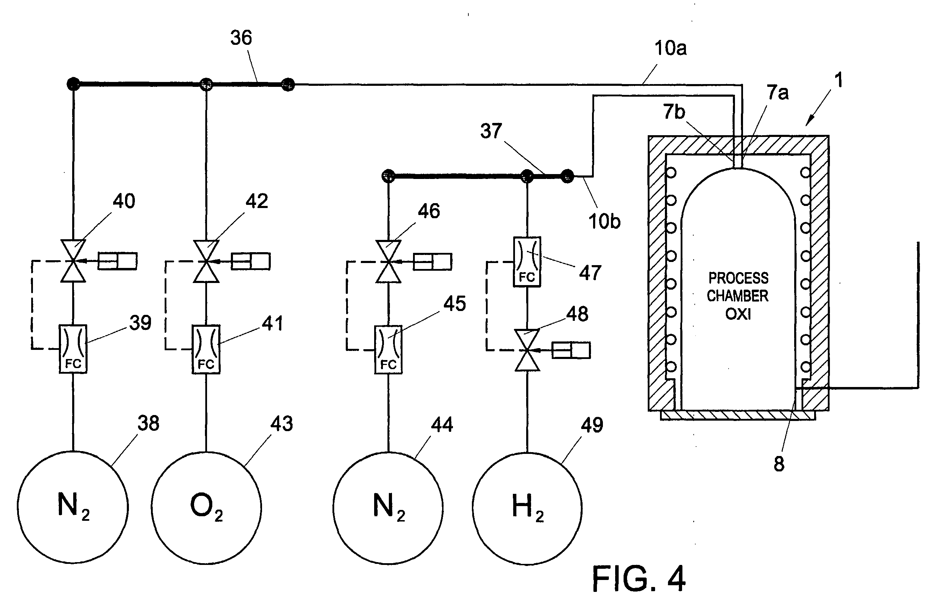

In Fig. 4, the gas source and pipe assembly 9 is provided with a first main supply pipe 10a having a downstream end thereof connected to a first gas supply 7a of the process chamber 1 and with a second main supply pipe 10b having a downstream end thereof connected to a second gas supply 7b of the process chamber 1. Connected to a upstream end of the first main pipe 10a is an oxygen mixture supply pipe 36. Connected to an upstream end of the second main pipe 10b is a hydrogen mixture supply pipe 37. Further, via a flow control 39 and a stop valve 40, an inert gas source 38 is connected to an upstream end of the oxygen mixture supply pipe 36. Via a flow control 41 and a stop valve 42, an oxygen source 43 between the upstream end of the oxygen mixture supply pipe 36 and the upstream end of the first main pipe 10a is connected to the oxygen mixture supply pipe 36. Via a flow control 45 and a stop valve 46, an inert gas source 44 is connected to an upstream end of the hydrogen mixture supply pipe 37. Via a flow control 47 and a stop valve 48, a hydrogen source 49 between the upstream end of the hydrogen mixture supply pipe 37 and the upstream end of the second main pipe 10b is connected to the hydrogen mixture supply pipe 37.

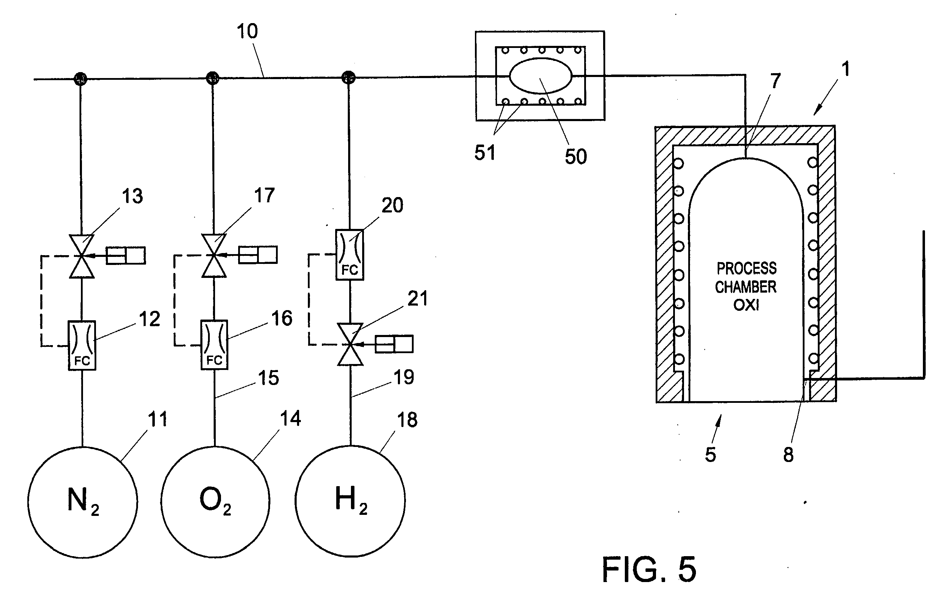

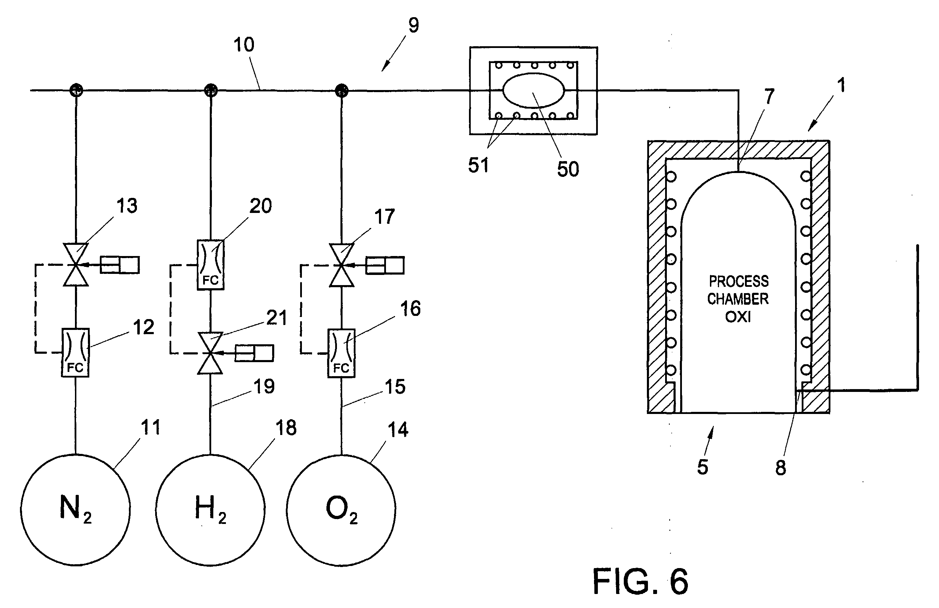

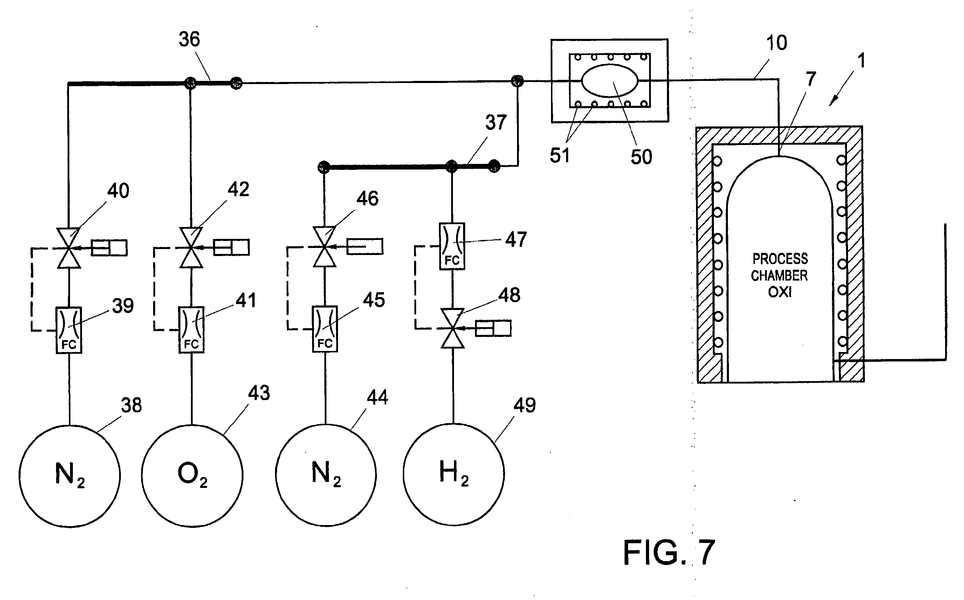

Figs. 5-7 show similar gas source and pipe assemblies as shown in Figs. 1-3 respectively, with the understanding that a reaction chamber 50 is incorporated into the main pipe 10. The reaction chamber comprises heating means 51, so that already in the reaction chamber 50, the third gas mixture supplied to the reaction chamber 50 is at least partially converted into a water vapor-containing third gas mixture. Preferably, the wall of the reaction chamber 50 comprises a material incapable of having a contaminating effect on the oxide layer to be formed, such as quartz.

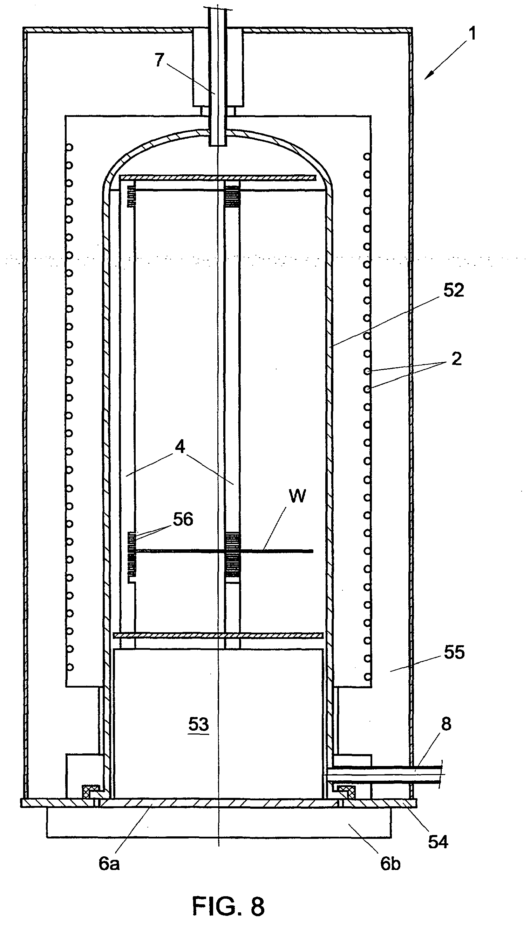

Fig. 8 shows an example of a process chamber 1 intended for a wafer processing method according to the invention. The process chamber 1 comprises a process pipe 52, typically manufactured from quartz. Disposed in the process pipe 52 is a boat 4 which is also preferably manufactured from quartz. In the boat 4, grooves 56 have been provided, in which a wafer W can in each case be included. Around the process pipe 52, heating means 2 extend in the form of a heating spiral. Around the heating spiral 2, an insulation sheath 55 extends, which provides that the least heat is lost. The boat 4 rests on a support 53 manufactured from quartz which also has insulating properties. At the top of the process chamber, a gas supply 7 opens. At the bottom of the process chamber, a gas discharge 8 opens. The support 53 rests on a door 6 arranged for up and down adjustment, by means of which the boat 4 can be moved out of the process pipe 52. The door 6 is composed of a quartz part 6a and a metal part 6b. The process pipe 52 is connected to and rests on a metal flange 54.

It is observed that in practice, the gas source and pipe assemblies comprise all types of additional provisions, such as nonreturn valves, reducing valves, manometers, pressure switches, flow switches, filters, needle valves and the like. For the sake of clarity, these parts are not shown in the schematically represented exemplary furnaces. However, it is directly clear to a skilled person where and for what purpose such parts could be fitted.

The operation of all exemplary furnaces shown is in conformity with the method according to the invention. In a first case, the oxygen is not contacted with the hydrogen until one or both substances have been highly diluted by mixing them with an inert gas such as, for instance, nitrogen or a noble gas. In a second case, the hydrogen flow rate is so small relative to the oxygen flow rate, that explosion is impossible. Hence, in that embodiment of the method, no use is made of dilution of the hydrogen and/or the oxygen with an inert gas. By means of the stop valves 13, 17, 21, 26, 28, 32, 34, 40, 42, 46 and 48 which may, for instance, be designed as pneumatic stop valves, and the flow controls 12, 16, 20, 25, 27, 31, 33, 39, 41, 45 and 47, the moment of supply of the various gases and the flow rates of the gases can be accurately controlled, to obtain the desired concentrations during mixing. If the hydrogen and/or the oxygen is diluted with an inert gas, the stop valves of the exemplary embodiments shown in Figs. 1-7, which close the hydrogen and oxygen supply, must not be opened until the stop valves which close the inert gas sources have been opened. If no dilution with an inert gas is used, the stop valve which closes the hydrogen supply must not be opened until the stop valve closing the oxygen supply has been opened.

Thus, due to the absence of a torch and the flameless reaction of hydrogen with oxygen used in the invention, it is possible to perform this reaction at a pressure deviating from the atmospheric pressure without the risk that the change of pressure causes conditions at which the torch does not function properly anymore.

## Claims

1. A method for forming, by means of water vapor, an oxidation layer on a number of wafers manufactured from semiconducting material, wherein a number of wafers are disposed one above the other and introduced into a vertical hot wall process chamber of a furnace in which a substantially atmospheric pressure in the range of 0,3 - 1,5 bar prevails and in which the wafers are brought to an increased temperature and maintained at that temperature for some time through heating of at least the walls of the furnace, **characterized in that** for forming the water vapor, a first gas, containing molecular hydrogen, is mixed with a second gas, containing molecular oxygen, after or during mixing of the first gas with the second gas, the third gas mixture formed therefrom being heated to a temperature of at least 700°C for effecting a gradual reaction between the hydrogen and the oxygen to form water vapor, the concentration of hydrogen in the first gas and/or the concentration of oxygen in the second gas and/or the ratio of the flow rates of the first and the second gas being such that during and after mixing of the first and the second gas, even in contact with the heated walls of the furnace process chamber explosion of the third gas mixture formed therefrom is impossible **in that** the reaction between the oxygen and the hydrogen does not propagate automatically, due to the concentration of the molecular hydrogen and/or the molecular oxygen in the third mixture, while the water vapor is formed without the use of a catalyst other than the wafer itself.

2. A method according to claim 1, **characterized in that** the heating of the third gas mixture takes place by introducing the third gas mixture into the process chamber.

3. A method according to claim 1, **characterized in that** the heating of the third gas mixture takes place by introducing it into a reaction chamber in which an increased temperature prevails, whereupon the water vapor-containing third gas mixture formed therein is introduced into the process chamber.

4. A method according to claim 2 or 3, **characterized in that** the introduction of the third gas mixture into the process chamber takes place from the top side of the process chamber.

5. A method according to any one of the preceding claims, **characterized in that** the third gas contains a concentration of hydrogen of from about 0.01 vol.% to about 6 vol.%, more in particular from about 0.1 vol.% to about 4 vol.%.

6. A method according to any one of the preceding claims, **characterized in that** the amount of hydrogen supplied with the first gas stream per unit of time is more than twice as large as the amount of oxygen supplied with the second gas stream per unit of time.

7. A method according to claim 6, **characterized in that** on the wafers manufactured from semiconducting material, electrodes containing transition metals are located.

8. A method according to claim 7, **characterized in that** the transition metal contains tungsten.

9. A method according to any one of the preceding claims, **characterized in that** the first and/or the second gas contains an inert gas in addition to hydrogen and oxygen respectively.

10. A method according to claim 9, **characterized in that** the inert gas is nitrogen.

11. A method according to claim 9, **characterized in that** the inert gas is a noble gas.

12. A method according to any one of the preceding claims, **characterized in that** the hydrogen gas contains the isotope deuterium in a concentration which is considerably higher than the concentration in which said isotope occurs naturally.

## Patentansprüche

1. Verfahren zur Bildung einer Oxidationsschicht auf einer Anzahl von Wafern, die aus einem Halbleitermaterial hergestellt sind, mittels Wasserdampf, wobei eine Anzahl von Wafern aufeinander angeordnet ist und in eine vertikale Heißwand-Verfahrenskammer eines Ofens eingeführt wird, in dem im Wesentlichen ein Atmosphärendruck in einem Bereich von 0,3 - 1,5 bar vorherrscht und in dem die Wafer auf eine erhöhte Temperatur gebracht werden und für einen bestimmten Zeitraum auf dieser Temperatur gehalten werden, indem wenigstens die Wände des Ofens erwärmt werden, **dadurch gekennzeichnet, dass** zur Bildung des Wasserdampfs ein erstes Gas, das molekularen Wasserstoff enthält, mit einem zweiten Gas, das molekularen Sauerstoff enthält, vermischt wird, nach dem oder während des Vermischens des ersten Gases mit dem zweiten Gas die daraus gebildete dritte Gasmischung auf eine Temperatur von wenigstens 700 °C erwärmt wird, wodurch eine allmähliche Reaktion zwischen dem Wasserstoff und dem Sauerstoff unter Bildung von Wasserdampf bewerkstelligt wird, wobei die Konzentration von Wasserstoff im ersten Gas und/oder die Konzentration von Sauerstoff im zweiten Gas und/oder das Verhältnis der Fließgeschwindigkeiten des ersten und des zweiten Gases so ist, dass während des Vermischens des ersten mit dem zweiten Gas oder danach sogar in Kontakt mit den erwärmten Wänden der Ofen-Verfahrenskammer eine Explosion der daraus gebildeten dritten Gasmischung dahingehend unmöglich ist, dass die Reaktion zwischen Sauerstoff und dem Wasserstoff aufgrund der Konzentration des molekularen Wasserstoffs und/oder des molekularen Sauerstoffs in der dritten Mischung nicht automatisch fortschreitet, wobei der Wasserdampf ohne die Verwendung eines Katalysators abgesehen vom Wafer selbst gebildet wird.

2. Verfahren nach Anspruch 1, **dadurch gekennzeichnet, dass** das Erwärmen der dritten Gasmischung erfolgt, indem die dritte Gasmischung in die Verfahrenskammer eingeführt wird.

3. Verfahren nach Anspruch 1, **dadurch gekennzeichnet, dass** das Erwärmen der dritten Gasmischung erfolgt, indem sie in eine Reaktionskammer eingeführt wird, in der eine erhöhte Temperatur vorherrscht, woraufhin die darin gebildete wasserdampfhaltige dritte Gasmischung in die Verfahrenskammer eingeführt wird.

4. Verfahren nach Anspruch 2 oder 3, **dadurch gekennzeichnet, dass** die Einführung der dritten Gasmischung in die Verfahrenskammer von der oberen Seite der Verfahrenskammer her erfolgt.

5. Verfahren nach einem der vorhergehenden Ansprüche, **dadurch gekennzeichnet, dass** das dritte Gas eine Wasserstoffkonzentration von etwa 0,01 Vol.-% bis etwa 6 Vol.-%, insbesondere von etwa 0,1 Vol.-% bis etwa 4 Vol.-% enthält.

6. Verfahren nach einem der vorhergehenden Ansprüche, **dadurch gekennzeichnet, dass** die Menge an Wasserstoff, die mit dem ersten Gasstrom pro Zeiteinheit zugeführt wird, mehr als doppelt so groß wie die Sauerstoffmenge ist, die mit dem zweiten Gasstrom pro Zeiteinheit zugeführt wird.

7. Verfahren nach Anspruch 6, **dadurch gekennzeichnet, dass** auf den Wafern, die aus Halbleitermaterial hergestellt sind, Übergangsmetalle enthaltende Elektroden angeordnet sind.

8. Verfahren nach Anspruch 7, **dadurch gekennzeichnet, dass** das Übergangsmetall Wolfram enthält.

9. Verfahren nach einem der vorhergehenden Ansprüche, **dadurch gekennzeichnet, dass** das erste und/oder zweite Gas zusätzlich zu Wasserstoff bzw. Sauerstoff ein Inertgas enthält.

10. Verfahren nach Anspruch 9, **dadurch gekennzeichnet, dass** das Inertgas Stickstoff ist.

11. Verfahren nach Anspruch 9, **dadurch gekennzeichnet, dass** das Inertgas ein Edelgas ist.

12. Verfahren nach einem der vorhergehenden Ansprüche, **dadurch gekennzeichnet, dass** das Wasserstoffgas das Isotop Deuterium in einer Konzentration enthält, die beträchtlich höher als die Konzentration ist, in der das Isotop in der Natur vorliegt.

## Revendications

1. Procédé pour former, au moyen de vapeur d'eau, une couche d'oxydation sur un certain nombre de tranches de silicium à base d'un matériau semi-conducteur, dans lequel un certain nombre de tranches de silicium sont disposées les unes sur les autres et introduites dans une chambre de traitement à parois chaudes de type vertical d'un four, dans laquelle règne une pression sensiblement atmosphérique dans la plage de 0,3-1,5 bars et dans laquelle les tranches de silicium sont portées à une température plus élevée et maintenues à cette température pendant un certain temps, par chauffage d'au moins les parois du four, **caractérisé en ce que** pour former la vapeur d'eau, un premier gaz, contenant de l'hydrogène moléculaire, est mélangé avec un second gaz, contenant de l'oxygène moléculaire, après ou pendant le mélange du premier gaz avec le second gaz, le troisième mélange gazeux formé à partir de ceux-ci est chauffé jusqu'à une température d'au moins 700°C pour induire une réaction progressive entre l'hydrogène et l'oxygène et former de la vapeur d'eau, la concentration d'hydrogène dans le premier gaz et/ou la concentration d'oxygène dans le second gaz et/ou le rapport des débits du premier et du second gaz étant tels que, pendant ou après le mélange du premier et du second gaz, même en contact avec les parois chauffées de la chambre de traitement du four, l'explosion du troisième mélange gazeux formé à partir de ceux-ci est impossible étant donné que la réaction entre l'oxygène et l'hydrogène ne se propage pas automatiquement, en raison de la concentration d'hydrogène moléculaire et/ou d'oxygène moléculaire dans le troisième mélange, pendant que la vapeur d'eau se forme sans l'utilisation d'un catalyseur autre que la tranche de silicium elle-même.

2. Procédé selon la revendication 1, **caractérisé en ce que** le chauffage du troisième mélange gazeux s'opère en introduisant le troisième mélange gazeux dans la chambre de traitement.

3. Procédé selon la revendication 1, **caractérisé en ce que** le chauffage du troisième mélange gazeux s'opère en l'introduisant dans une chambre de réaction dans laquelle règne une température plus élevée, après quoi le troisième mélange gazeux contenant de la vapeur d'eau formé dans celle-ci est introduit dans la chambre de traitement.

4. Procédé selon la revendication 2 ou 3, **caractérisé en ce que** l'introduction du troisième mélange gazeux dans la chambre de traitement s'opère par le haut de la chambre de traitement.

5. Procédé selon l'une quelconque des revendications précédentes, **caractérisé en ce que** le troisième gaz contient une concentration d'hydrogène d'environ 0,01 à environ 6 % en volume, plus particulièrement, d'environ 0,1 à environ 4 % en volume.

6. Procédé selon l'une quelconque des revendications précédentes, **caractérisé en ce que** la quantité d'hydrogène fournie dans le premier flux gazeux par unité de temps est deux fois plus importante que la quantité d'oxygène fournie dans le second flux gazeux par unité de temps.

7. Procédé selon la revendication 6, **caractérisé en ce que** des électrodes contenant des métaux de transition sont placées sur les tranches de silicium à base d'un matériau semi-conducteur.

8. Procédé selon la revendication 7, **caractérisé en ce que** le métal de transition contient du tungstène.

9. Procédé selon l'une quelconque des revendications précédentes, **caractérisé en ce que** le premier et/ou le second gaz contient/contiennent un gaz inerte en plus de l'hydrogène et de l'oxygène, respectivement.

10. Procédé selon la revendication 9, **caractérisé en ce que** le gaz inerte est l'azote.

11. Procédé selon la revendication 9, **caractérisé en ce que** le gaz inerte est un gaz noble.

12. Procédé selon l'une quelconque des revendications précédentes, **caractérisé en ce que** le gaz hydrogène contient l'isotope deutérium en une concentration qui est considérablement plus élevée que la concentration à laquelle ledit isotope existe à l'état naturel.
